Europäisches Patentamt

European Patent Office

Office européen des brevets

(19)

(11) EP 0 955 390 A2

(12) EUROPEAN PATENT APPLICATION

(43) Date of publication:
10.11.1999 Bulletin 1999/45

(51) Int. Cl.$^6$: C23C 14/00, C23C 14/34, C23C 14/06

(21) Application number: 99104585.7

(22) Date of filing: 08.03.1999

(84) Designated Contracting States:
AT BE CH CY DE DK ES FI FR GB GR IE IT LI LU MC NL PT SE
Designated Extension States:
AL LT LV MK RO SI

(30) Priority: 29.04.1998 US 69256

(71) Applicant:
GENERAL MOTORS CORPORATION
Detroit Michigan 48202 (US)

(72) Inventor: Yin, Shiao F.
Novi, Michigan 48375 (US)

(74) Representative:
Manitz, Finsterwald & Partner
Postfach 22 16 11
80506 München (DE)

(54) Low temperature deposition of transition metal nitrides

(57) Transition metal nitrides, such as titanium nitride, are formed a low temperatures (for example, below 175°C) on a negatively-biased substrate (34) by balanced magnetron sputtering of the metal atoms into an inductively-coupled plasma (44) of positive inert gas and nitrogen ions at the substrate. The negative bias of the substrate and the magnetron target and the power of the induction current are controlled to achieve a ratio of positive inert gas and nitrogen ions to metal atoms to synthesize the metal nitride coating at temperatures in the range of about 100K to 300K or higher.

FIG. 1

## Description

### TECHNICAL FIELD

This invention pertains to the synthesis of thin coatings of transition metal nitrides, such as TiN, on workpiece surfaces. More specifically, it pertains to the formation of such coatings on heat-sensitive substrates, such as hardened steels, at low temperatures without damaging the workpiece.

### BACKGROUND OF THE INVENTION

Plasma processing of materials has gained wide industrial acceptance in the last 20 years. Electronic applications of plasma processing concentrate on plasma-assisted etching for pattern definition and plasma-assisted deposition of thin film interconnects and diffusion barriers. Non-electronic applications of plasma processing concentrate on plasma-assisted deposition of metal, ceramic, and composite coatings for mechanical applications such as friction reduction, wear protection, and corrosion protection. Synthesis of thin films and coatings by physical vapor deposition (PVD) and chemical vapor deposition (CVD) has been studied extensively. Since typical CVD depositions occur at higher temperatures, except for special situations where components made of high temperature alloys are coated, surface coatings on components for mechanical applications are more often made by PVD techniques.

Plasma-assisted PVD deposition of hard ceramic coatings generally involves the supply of metal fluxes to the component surface to be coated. The component surface is immersed in a plasma made up of inert or a mixture of inert and reactive gases. During coating formation, the coating surface is subjected to continuous fluxes of metal atoms and is under bombardment from fluxes of ions and neutrals from the plasma. A major category of coating formation by plasma-assisted PVD is that of sputtering.

In conventional diode sputtering, the workpiece to be coated and the material to be deposited form, respectively, the anode and the cathode of a parallel plate diode system, which is immersed in an inert or reactive gas environment. A glow discharge is set up by negatively biasing the cathode (target, typically a metal), and the cathode material is sputtered and forms the supply of metal flux to the surface to be coated. Using close-loop magnetic fields above the cathode surface to confine secondary electrons, the ionization efficiency of the diode glow discharge is further increased. This practice called magnetron sputtering has become a widely used technique in the last 20 years for synthesizing a wide variety of metal and ceramic thin films and coatings.

Mechanical applications involving surface coatings usually require fully dense coatings. To achieve full coating density at relatively low deposition temperatures, especially for ceramic materials such as the transition metal nitrides, many studies have found that a minimum amount of ion bombardment is necessary for a given rate of supply of metal species. This in turn dictates that a minimum plasma density has to be maintained at the workpiece surface during coating formation. For direct current diode sputtering systems including magnetron systems, increasing plasma density means that the input power into the cathode has to be increased. As a result, the sputtering rate increases as the plasma density increases and the ratio of ion flux to metal flux cannot be controlled independently. In addition, in radio-frequency (rf) diode sputtering systems, increasing input power to the cathode also causes the plasma potential to increase. Since the plasma potential affects the energy of ions bombarding the coating surface, ion energy and ion flux cannot be controlled independently in this case. In plasma-assisted etching of semiconductor materials as well as in plasma-assisted deposition of metal and ceramic coatings, many studies have shown that high energy ions cause damage and degrade device and coating properties. For these reasons the plasma processing community has been actively searching for techniques for generating plasmas which allow for independent control of ion energy and ion flux as well as offer low energy ionic species.

At the present time, the most prominent synthesis technique for coatings with mechanical applications, which allows increased ion bombardment at a given rate of supply of metal species, is that of unbalanced magnetron (UBM) sputtering. By altering the magnetic field strength of the magnetic pole pieces in a conventional magnetron, magnetic fields were made to extend to the substrate region. Secondary electrons from the cathode are guided by the extending magnetic field to the substrate region and greatly increase the ionization efficiency. This technique has been commercialized by coating companies and production scale batch coating machines producing hard wear protection coatings such as titanium nitride (TiN), titanium aluminum nitride (TiAlN), and diamond-like carbon (DLC) have been in operation for a number of years.

Despite the commercial success of UBM sputtering, a number of improvements of the technique are possible. Prior to coating deposition, surface cleaning of the component to be coated has to be performed to remove residual surface oxide and hydrocarbon. Without proper cleaning, coating adhesion to the substrate tends to be poor. In sputter deposition including UBM sputtering, component surface cleaning is usually accomplished by glow discharge sputtering. The workpiece is immersed in an inert gas such as Ar or a combination of inert and reducing gases such as Ar and $H_2$. It is subjected to a negative bias potential, which sets up a glow discharge and attracts positive ions from the glow discharge to bombard its surface. Since the ionization efficiency of pure glow discharges is very low, high negative bias (500 - 1000V) and high gas pressure (> 30 mTorr) are required to set up the glow discharge. The high negative bias required causes unwanted arcing and the low ionization efficiency causes slow and inefficient surface cleaning. To remedy this, it is common practice to supply low power to the sputter target cathodes. The additional plasma generation from the cathode regions, with its higher ionization efficiency due to the magnetron confinement, helps to increase the plasma density near the workpiece surface and thus the cleaning efficiency. However, even with the low power supplied to the sputter target cathodes, some sputtering of the cathode materials does occur. In this situation, surface cleaning becomes a competition between sputter cleaning and sputter deposition. Net cleaning or net deposition is both possible depending on operating parameters, leading to process variability and irreproducibility. Because of the participation of the cathode discharge in the cleaning process, it is also difficult to explore different gas chemistry for more effective surface cleaning as this may lead to unwanted chemical reactions on the cathode surface. To improve this situation regarding component surface cleaning, it is desirable to have a separately generated plasma totally independent from the sputter cathodes.

In a UBM sputtering chamber, because the increased plasma density comes from electron confinement by the magnetic fields emanating from the cathode surface region, the plasma density at the workpiece depends on workpiece distance to the cathode and tends to be spatially non-uniform. This also leads to coating quality variability depending on the workpiece location within the chamber. This has implications for production issues such as fixturing, particularly the fixturing of three dimensional workpieces.

Not coincidentally, intensive research has been carried out searching for plasma sources which offer high density, uniformity, and importantly, independent control of ion energy and ion flux. A number of plasma sources have been extensively studied over the past five years, including electron cyclotron resonance (ECR) discharges, helicon discharges, and inductively coupled plasma (ICP) discharges. The first two techniques require the use of external magnetic fields, which is not required for the ICP plasma.

Because of the aforementioned reasons, there is a need to provide a method of using high density plasmas for deposition of hard wear resistant coatings. This invention uses an ICP plasma-assisted sputter/ion plating system because of its simplicity of design and its potential ease for production scale-up. In this specification the capability of this deposition system is demonstrated by synthesizing TiN, a well known and relatively easily characterized ceramic coating material. This choice is dictated by the potential of TiN to serve as a standard and an illustration of a practice applicable to the synthesis and deposition of members of a family of transition metal nitrides.

## SUMMARY OF THE INVENTION

This invention provides a method of applying a transition metal nitride coating on a workpiece at relatively low substrate temperatures of, for example, 135K to 450K. Thus, the process is particularly useful for coating temperature-sensitive workpieces such as carburized and case hardened steels or other hardened metals where a high temperature coating process would reduce or remove the hardness of the substrate.

In accordance with the practice of the invention, dense metal nitride coatings can be deposited including chromium nitride (CrN), hafnium nitride (HaN), niobium nitride (NbN), tantalum nitride (TaN), titanium nitride (TiN), tungsten nitride (WN) and zirconium nitride (ZrN) or mixtures or alloys of such nitrides.

In general terms the coating is synthesized by creating a plasma between a transition metal containing cathode and an anodic workpiece with a flow of metal atoms from the cathode to the anode in a subatmospheric plasma medium of nitrogen and noble gas ions. The plasma surrounding the anodic workpiece is generated, independently of power applied to the cathode, by a radio frequency electric current through inductive coupling. The effect of the independently controlled inductively coupled plasma surrounding the workpiece is to markedly increase the ion flux density ($J_i$) at the workpiece surface. The increased ratio of inert gas ion and nitrogen ion flux density ($J_i$), especially the flux density of nitrogen ions, to metal atom flux density (the ratio, $J_i/J_{Me}$) at the workpiece surface promotes the synthesis and deposition of a dense, crystalline coating of metal nitride of up to several micrometers in thickness at the relatively low temperatures mentioned above.

In one embodiment of the invention, transition metal cathodes sputtered in the conventional magnetron configuration are used to supply metal atoms to the workpiece surface. However, other means of supplying the metal flux, such as electron beam evaporation, can equally well be used.

The effect of changing the growth temperature, $T_g$, of the transition metal nitride coating has been demonstrated using an ICP plasma-assisted magnetron sputter technique in the formation of TiN coatings with a cooled support for the workpiece. In a series of experiments the temperature of the workpiece was maintained at values in the range of 90K to 700K. Since the melting point, $T_m$, of TiN is about 3200K, these growth temperatures were only about three percent to twenty percent of the melting point. The experimental results showed that the film formation and densification process occurring at $J_i/J_{Ti}$ of about 50 is largely independent of growth temperature. In general, conduct of the subject coating synthesis process at ratios of ion flux density to transition metal atom flux density in the range of about 10 to 60 is suitable to achieve dense crystalline coatings at temperatures of 175°C or lower. The subject invention thus provides a low temperature synthesis and densification process for transition metal nitride coatings on workpieces.

Other objects and advantages of the invention will become more apparent from a detailed description which follows. Reference will be made to the drawing figures that are described in the next section.

BRIEF DESCRIPTION OF THE DRAWINGS

Figure 1 is an elevation view of a transition metal nitride coating synthesis apparatus for an embodiment of the subject invention using an ICP plasma-assisted magnetron sputter technique.

Figure 2A is a sectional view taken at 2A-2A of Figure 1 showing the arrangement of the unbalanced magnetron sources and a workpiece and workpiece holder in a chamber of Figure 1.

Figure 2B is a sectional view taken at 2B-2B of Figure 1 showing the relationship of the induction coils, magnetrons and workpiece in the apparatus of Figure 1.

Figure 3 is a graph of sputter chamber total pressure as a function of nitrogen input flow rate while sputtering two titanium cathodes in a mixture of nitrogen and argon. The argon flow was fixed at 22.0 sccm. During sputtering the total ICP input powers were 0 W ($\bigcirc$) and 900 W ($\square$), respectively.

Figure 4 is a graph of measured Langmuir probe current as a function of total ICP input power. The probe was biased at -100V.

Figure 5 is a graph of measured sample bias current as a function of measured probe current. The sample holder was subjected to a constant negative dc bias voltage of 20V ($\bigcirc$) or 100V ($\square$).

Figure 6 is a group of three X-ray diffraction patterns of three TiN films deposited on steel disks at about 100K, the total ICP input power during deposition was 0 W, 650 W and 1100 W, respectively.

Figure 7 is a group of three X-ray diffraction patterns of three TiN films deposited on steel disks at about 300K, the total ICP input power during deposition was 0 W, 650 W and 1100 W, respectively.

Figure 8 is a graph of the near normal incidence optical reflectance of two TiN films deposited at about 100K, the total ICP input power was 0 W (squares) and 650 W (circles), respectively. Solid lines are least square fits of data.

Figure 9 is a group of four X-ray diffraction patterns from a series of TiN coated 1045 steel coupons. The sample bias voltage was held constant at -20V and the sample holder was water cooled for the whole series. The bottom to top patterns correspond to total powers of 0, 600, 900 and 1100 W, respectively.

Figure 10 is a graph of the near normal optical reflectance of a series of TiN coatings on 1045 steel coupons. The sample bias voltage was held constant at -20V and the sample holder was water cooled for the whole series. The total ICP input power was varied from 0 to 600, 900 and 1100 W, respectively.

DESCRIPTION OF THE PREFERRED EMBODIMENT

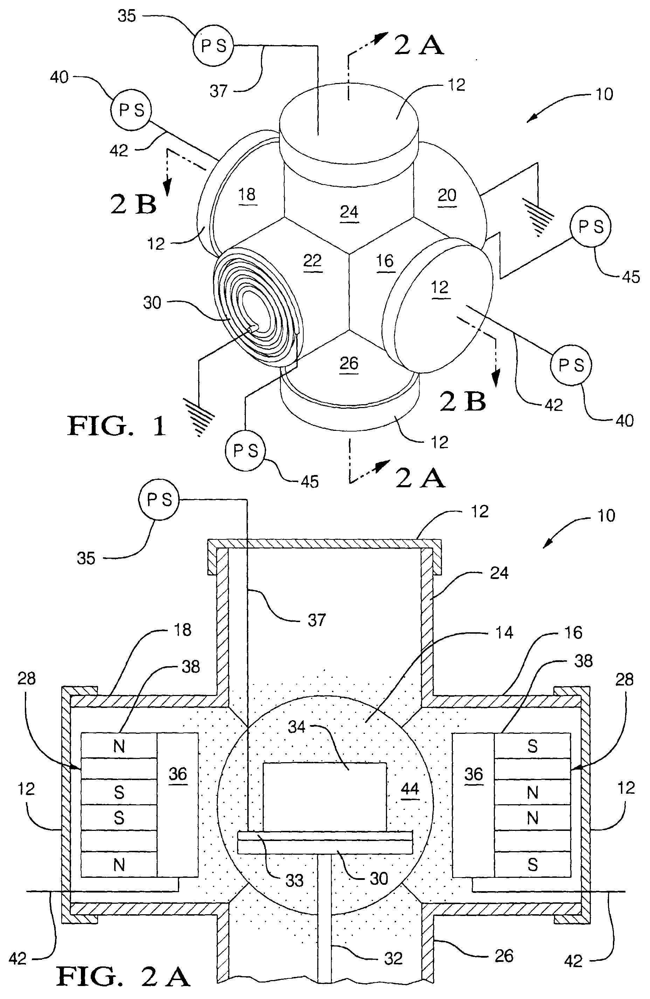

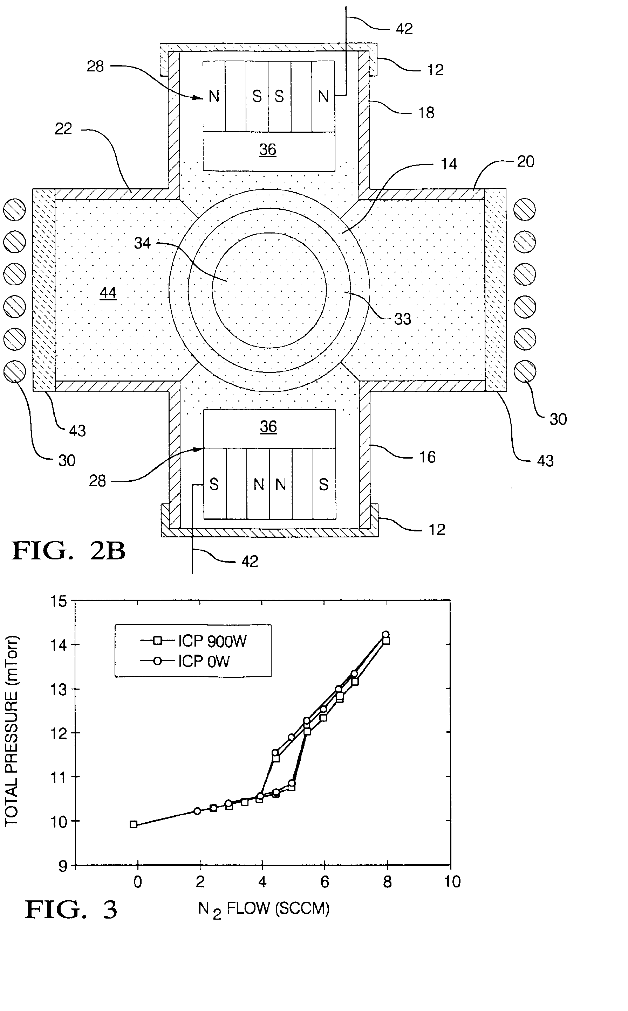

An ICP assisted sputter/ion plating system is shown at 10 in Figures 1, 2A and 2B. The system 10 comprises a chamber 14 formed by the intersection of three mutually perpendicular hollow stainless steel cylinders. This arrangement provides an internal central, generally cubical chamber 14 with six hollow cylindrical access arms 16, 18, 20, 22, 24 and 26 that are either in-line or perpendicular to each other. These arms have identical six-inch external diameters. This six-way cross structure provided the internal coating chamber 14 with conventional magnetron sputter targets 28 in arms 16 and 18, and flat spiral induction coils 30 at the ends of arms 20 and 22. The internal structure of system 10 is seen in Figures 2A and 2B.

Figure 2A is a vertical section through system 10. A rotatable workpiece holder 30 is mounted centrally in chamber 14. Workpiece holder 30 is carried on rotatable shaft 32 that extends down into arm 26. Workpieces 34 to be coated in accordance with the invention are manipulated through arm 24, by means not shown, and placed on holder 30. Workpieces to be coated are mounted on electrically-isolated holders that can be independently biased. The workpiece holder 30 comprises a Cu piece 33 that can be cooled with water, liquid nitrogen or the like (coolant could be circulated through shaft 32, passages not shown) to provide indirect cooling to the workpiece. Direct current power source means, indicated schematically at 35, with lead 37 through arm 24 (and its removable closure cover 12) is employed for applying a suitable negative dc bias (e.g., -10V to -100V) to workpiece(s) during coating.

Magnetron sputter devices 28 comprise a transition metal (e.g., Ti) cathodic target 36 mounted on magnetron bodies 38. Ti targets 36 are given suitable negative charges from power sources 40 through leads 42 in arms 16 and 18. Leads 42 pass through covers 12 on arms 16 and 18. As is known, the effect of a suitable negative charge (e.g., -300V to -600V) at a suitable power level is to sputter titanium atoms from the target. Gas atoms in the vicinity of the target such as argon atoms are ionized. Magnetron bodies 38 comprise permanent magnets as indicated by the suitably positioned and sized north and south poles. As suggested by the schematic representation, the magnetic field at each magnetron 38 is balanced.

As seen in Figures 1 and 2B, two opposing planar exciting coils 30 excite a plasma column (stippled area, 44) through two quartz windows 43. The coils 30 are positioned generally coplanar with the magnetron/titanium targets 28 but (in this example) rotated 90° from the targets. The induction coupled plasma 44 spans the entire cross-section including workpiece holder 30 and workpiece 34. One end of each of the exciting coils connects through tuning networks to 13.56 MHz rf power supplies 45 and the other end is grounded. In accordance with embodiments discussed herein, rf power was supplied equally to the coils 40 and the total power was varied in the following described examples from about 600 W total to 1100 W total.

The inductively coupled plasma is illustrated at 44 while the Ti cathode/magnetron plasma was not specifically illustrated. This was done to simplify the drawings. The ICP is produced wholly independently of the cathode plasma and is usually much denser. But the controlled use of the two independently generated plasmas is an important aspect of this invention.

Certain basic features of an apparatus for the practice of this invention have been illustrated in connection with the six-arm cross depicted at 10 in Figures 1, 2A and 2B. However, in the execution of the process additional equipment and apparatus is required to evacuate chamber 14, supply controlled amounts of noble gas and nitrogen, measure pressure, load workpieces, analyze the plasma, provide a view port and the like. For these purposes and others, similar six-arm cross vessels may be attached below arm 26 and above arm 24. Suitable connections for the above purposes and others that will become apparent from the following description may be made through the additional ten openings thus provided.

Description of Coating Practices

The practice of the invention will be illustrated in the application of titanium nitride coatings to hardened steel workpieces.

Samples in the form of 1" diameter x 0.125" thick 1045 steel coupons are clamped onto the Cu workpiece holder. The 1045 steel coupons had been carburized and case hardened to a case depth of ~0.5 mm and a hardness of ~60 Rc. Sample transfer is accomplished through arm 24 of the cross perpendicular to the ICP/sputter arms. The sample surface temperature during coating deposition is measured by attaching two thermal couples to a sacrificial 1045 steel coupon. Conventional and electron-emitting Langmuir probes, constructed from 125 $\mu$m and 50 $\mu$m diameter tungsten wires, are inserted into the plasma through port 28 for diagnostics.

The coating chamber was evacuated to a base pressure less than $1 \times 10^{-7}$ Torr. The sample surface was first sputter cleaned in an argon plasma generated through the use of the ICP exciting coils 30.

Following cleaning of the steel coupon surface, the coating process was started. Argon was used as a substantially unreactive plasma medium and nitrogen was used to form the reactive nitrogen ion species in the plasma. In the following examples, argon was flowed into the chamber at a rate of about 22 standard cubic centimeters per minute (sccm) and nitrogen was flowed into the chamber at rates of 0 to 8 sccm. In operation the total pressure of the plasma was about ten to fourteen millitorr.

The negative bias applied to the magnetron sputtering target and the workpieces were varied as stated in results stated below. Likewise, the power to the ICP coils were varied as stated. Coatings with thicknesses varying from 0.5 to 5 micrometers were deposited at a typical rate of 1 to 1.5 micrometers per hour.

The identity and quality of the coatings were evaluated by X-ray diffraction and optical reflectance. X-ray diffraction measurements were carried out on a Siemans D500 $\theta$ - $\theta$ diffractometer using Cu K$\alpha$ radiation. Near normal optical reflectance measurements were carried out on a Perkin-Elmer $\lambda$-9 spectrometer with an integrated sphere attachment.

RESULTS AND DISCUSSION

System Characteristics

Figure 3 shows typical total system pressures versus $N_2$ input flow obtained in the deposition system by sputtering two Ti cathodes reactively in a mixture of Ar and $N_2$. The discharge current was 1.0 A for each of the Ti cathodes. The total system pressure exhibits the well known hysteresis versus $N_2$ flow. The same pressure hysteresis curve is obtained with and without the ICP, indicating that the addition of the ICP plasma does not affect chemical reactions occurring at cathode surfaces.

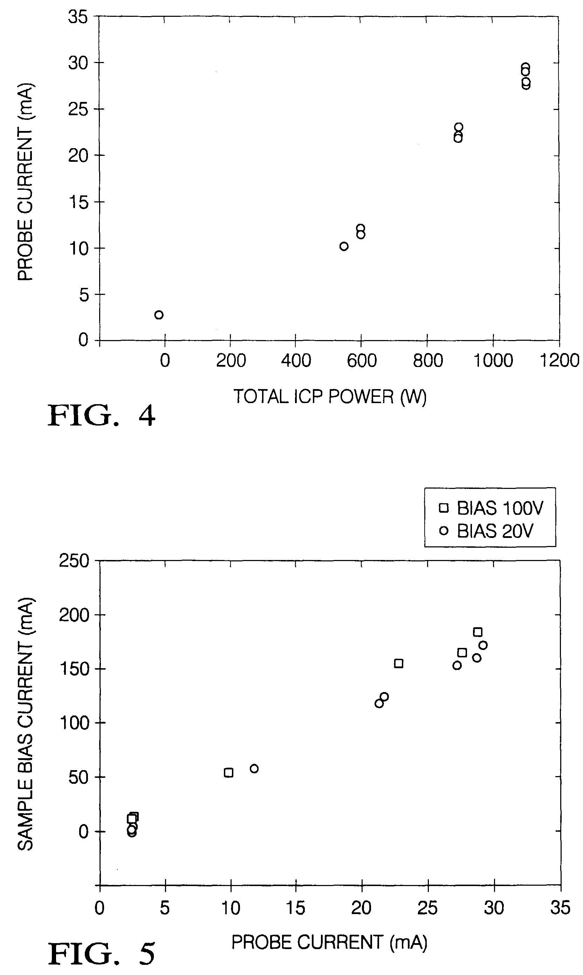

For the conventional Langmuir probe, in the ion collection regime with the probe biased negatively, the ion collection current yields a measure of the ion density in the plasma. Figure 4 shows measured Langmuir probe ion current as a function of total ICP input power, with the probe biased at -100V. The total ICP input power was divided equally between the two exciting coils. The Ar and $N_2$ input flow ratio was fixed at 50:8 during sputtering and the total chamber pressure was ~10 mTorr. All subsequent TiN depositions were carried out at these conditions. With no input power to the ICP exciting coils, operating the two opposing magnetron gives rise to probe currents ~2.5 mA. With a total input power of 1100W into the exciting coils, probe currents ~30 mA are measured. Figure 4 shows that the ion current increases by a factor of 10 due to the addition of the ICP plasma. Figure 5 shows the sample bias current, measured from the electrically-isolated sample holder subjected to a constant dc bias voltage. Figure 5 shows that the probe current indeed correlates linearly with the sample bias current, and thus yields a measure of the degree of ion bombardment the samples are subjected to inside the plasma zone. There is a slight increase of the sample bias current with increasing bias voltage. Figures 4 and 5 show the ability of the subject ICP assisted sputter/ion plating system to adjust the ion flux density to the sample surface independently from the sample bias voltage.

Evaluation of Coatings and Coating Process

A series of experiments on synthesis of TiN coatings were carried out where the steady state growth temperature was measured as a function of the total power to the ICP coils ($P_{ICP}$) as the substrate holder was subjected to cooling by liquid nitrogen, water, and not cooling, respectively. With liquid nitrogen cooling, the deposition temperature ranged from 94K to 123K, as $P_{ICP}$ increased from 0 to 1100W. The corresponding deposition temperature ranged from 283K to 294K with water cooling, and 400K to 685K with no cooling, respectively.

Rutherford backscattering spectrometry (RBS) was used to measure the total amount of Ti in TiN films. In this series of experiments, the net Ti flux density, given by the total amount of Ti incorporated into the TiN films normalized by the total deposition time, was measured to be $\sim 2.5 \times 10^{14}$ cm$^{-2}$ sec$^{-1}$ and found to be independent of $P_{ICP}$ and growth temperature. The ion flux density, $J_i$, was measured by a planar Langmuir probe, as a function of $P_{ICP}$. $J_i$ increases linearly with increasing $P_{ICP}$ due to increasing plasma density. In an $N_2$/Ar plasma with a gas input flow ratio of 8/50, $J_i$ is $\sim 120 \times 10^{14}$ cm$^{-2}$ sec$^{-1}$ at $P_{ICP}$ of 650W. Since the incoming Ti flux has been kept constant by fixing the Ti cathode current, the constant net Ti flux density indicates that there is no significant amount of Ti resputtering from the growth surface as $J_i$ increases. The measured net Ti flux density can thus be equated to the incoming Ti flux density $J_{Ti}$. The effect of changing $P_{ICP}$ is to change $J_i/J_{Ti}$ while keeping $J_{Ti}$ a constant.

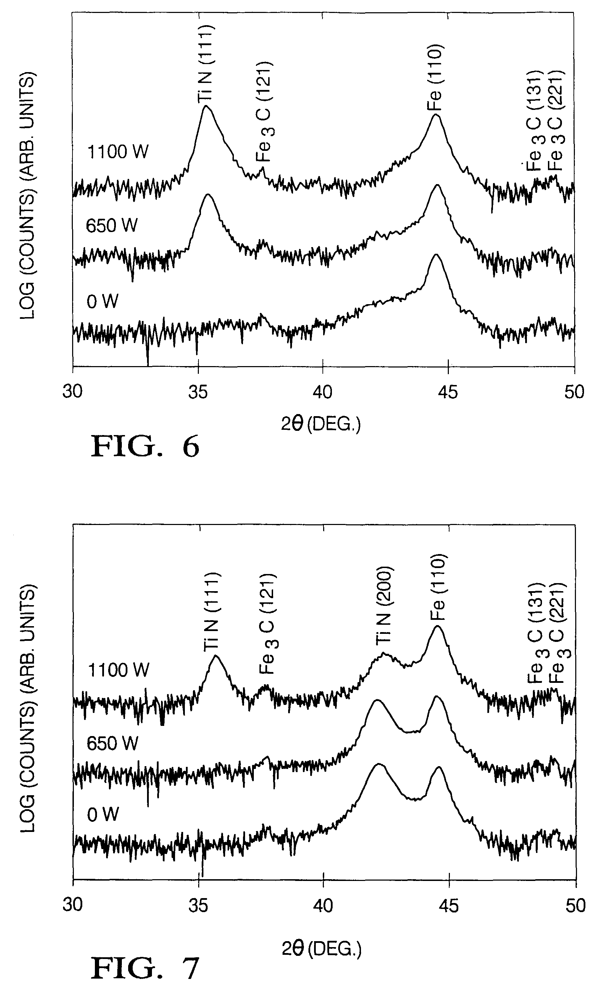

Figure 6 shows x-ray diffraction patterns of three TiN films deposited at $\sim 100$K. $P_{ICP}$ during deposition was 0W, 650W, and 1100W, respectively. Besides the Fe(110) and Fe$_3$C Bragg peaks from the steel substrate, only very broad features exist in the diffraction pattern at $P_{ICP}$ of 0W, indicating poor crystallinity of the TiN coating. As $P_{ICP}$ increased to 650W and 1100W, distinct TiN(111) reflection develops which shows the development of a predominant (111) texture as $J_i/J_{Ti}$ increases, indicating much improved crystallinity, Figure 7 shows X-ray diffraction patterns of three TiN films deposited at $\sim 300$K. The predominant (100) texture changes to a mixture of (100) and (111) texture as $P_{ICP}$ changes from 0W to 1100W. The improvement of TiN crystallinity with increasing $J_i/J_{Ti}$ is much more pronounced at $\sim 100$K.

Plan-view transmission electron microscopy was used to further examine the microstructure of the TiN coatings. Selected area electron diffraction shows that the TiN coating deposited at 94K with $P_{ICP}$ of 0W is of the cubic B1 structure. High resolution dark-field microscopy shows randomly oriented B1 crystallites $\sim 5$-10 nm in diameter. Examination of the underfocus/overfocus contrast of this specimen in the bright-field mode reveals void-like contrasts at grain boundaries and suggests that this film is porous. High resolution dark-field microscopy of the TiN coating deposited at 123K with $P_{ICP}$ of 1100W shows larger B1-TiN grains. Examination of the underfocus/overfocus contrast reveals no void-like contrast and suggests that this film is dense.

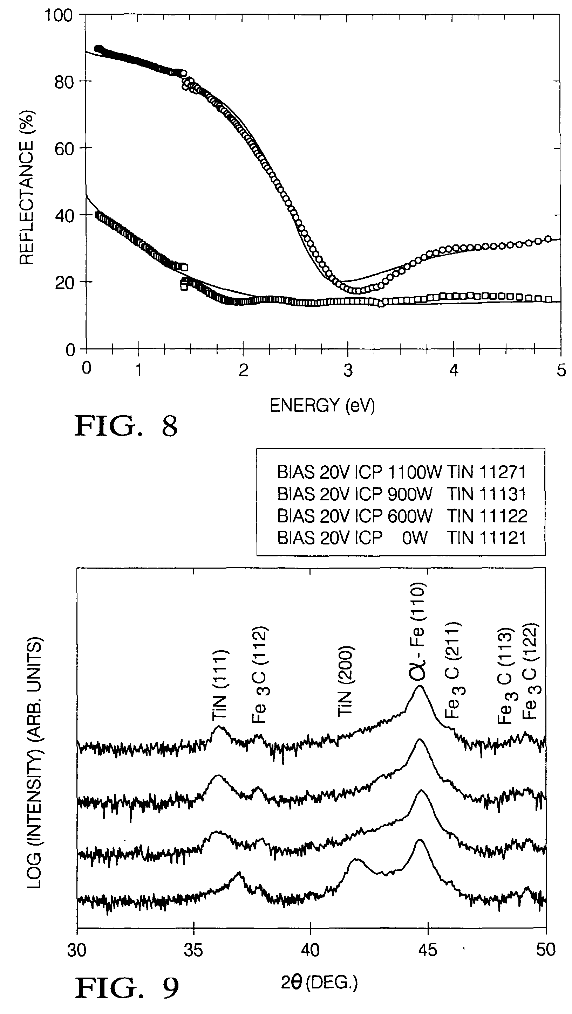

Figure 8 shows near normal optical reflectance of two TiN films deposited with liquid nitrogen cooling and $P_{ICP}$ of 0W and 650W, respectively. The growth temperature at $P_{ICP}$ of 0W and 650W was 93K and 110K, respectively. The TiN film deposited at 0W is dark brown with a low near-infrared reflectivity. At 650W, the TiN film is gold in color with a near-infrared reflectivity $\sim 90\%$.

Examination of TiN microstructure and optical properties shown above shows that at low $J_i/J_{Ti}$ ($P_{ICP} = 0$W), densification of TiN film is highly dependent on growth temperature. In contrast, at $J_i/J_{Ti} \sim 50$ ($P_{ICP} = 650$W), dense TiN film can be formed at $\sim 100$K and $\sim 300$K, and the densification process appears to be rather independent of temperature and can occur at a ratio of coating growth temperature to coating melting temperature as low as 0.04.

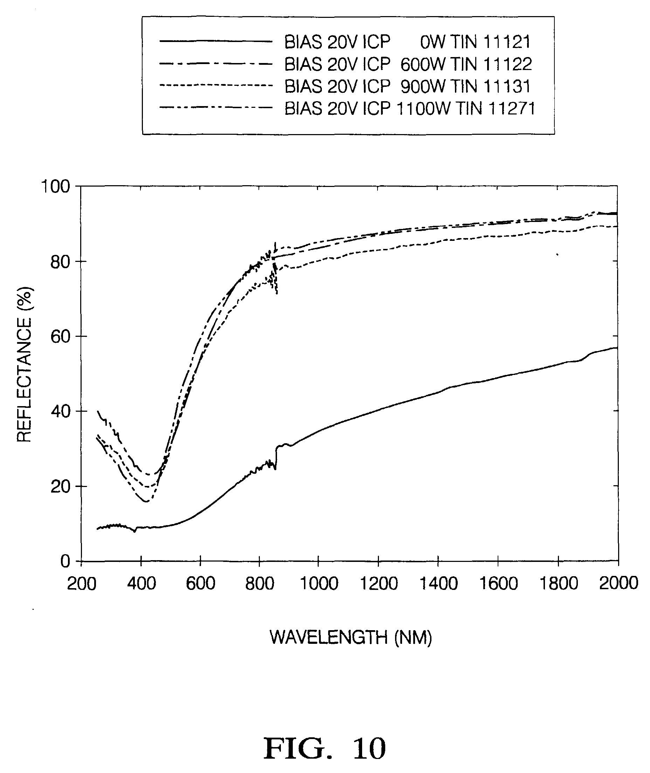

Figure 9 shows X-ray diffraction patterns from a series of TIN coated 1045 steel coupons. During coating deposition, the ICP input power was varied from 0W to 1100W while the sample bias voltage was maintained constant at -20V. The sample holder was water cooled during this series of runs and the deposition temperature ranged from 25°C to 115°C. The observed Bragg peaks can be indexed to the ferrite Fe and the cementite Fe$_3$C phases of the steel substrate and the TiN coating. The presence of cementite Fe$_3$C peaks is probably a consequence of the carburizing and heat treatment. Without the ICP plasma, the TiN coating formed shows a mixture of (111) and (200) textures. With increasing ICP input power, the (200) orientation gradually decreases and the coating is almost completely (111) oriented at an ICP input power of 1100W. Figure 10 shows measured near normal optical reflectance of the TiN coated surfaces of the 1045 steel coupons, with sample bias voltage maintained constant at -20V. As the ion flux density to the substrate surface increases, the near infrared reflectance showed a pronounced increase indicating improved TiN crystallinity. Combining results shown in Figures 9 and 10, it is seen that the ICP plasma assist improves the crystallinity of TiN coatings deposited around room temperature and that TiN coatings of good crystalline quality can be synthesized at 120° C or below by the ICP assisted sputter deposition technique.

Considering all evaluations of coatings produced by the method of this invention, it is concluded that TiN coatings of good crystalline quality can be synthesized on steel and other substrates at 175°C or below by this ICP assisted sputter deposition technique.

It is found that the workpiece surface temperature increases rather linearly with increasing ICP input power for a given sample bias voltage. With water cooling, the workpiece surface temperature stayed at ~170°C or below, regardless of ICP input power. Without water cooling, the maximum measured sample surface temperature at a workpiece bias of -20V and an ICP power of 1100W was ~320°C. Since carburized and case hardened steel is susceptible to temper softening, coating deposition onto such steel parts will be constrained to occur at temperatures below the tempering temperature of the steel. The possible surface softening was checked by making five Rockwell indentations with 150 kG load on 3 TiN coated 1045 steel coupons. TiN depositions for those three coupons were carried out at the same total ICP input power of 1100W. Bias voltages were -20V and -100V for two of the coated coupons, respectively. The sample holder was cooled during TiN deposition on these two coupons. The bias voltage for the third coupon was -20V, and water cooling to the sample holder was off during TiN deposition on this coupon. The deposition temperatures during the two water cooled runs were ~115°C and ~160°C, respectively. The measured average hardnesses of these two coupons were 60.2 Rc and 60 Rc, respectively, in agreement with the original coupon hardness after carburizing and case hardening. Thus, no softening occurred for any TiN deposition when the temperature stayed below ~170°C. Without water cooling, the deposition temperature was measured to be ~315°C. The measured average hardness was 56.2 Rc on this coupon, showing that it was softened at this deposition temperature.

The above described method is suitable for forming transition metal nitrides on substrates at surface temperatures of 175°C or lower. Specifically, it is applicable to the formation of coatings where the transition metal is an element selected from the group consisting of chromium, hafnium, niobium, tantalum, titanium, tungsten and zirconium. In each specific embodiment, a suitable balance of independently controllable parameters is determined. The negative bias of the anodic substrate, the dc power applied to the cathode target and the rf power applied to the induction coil(s) may each be optimized to produce dense crystalline coatings of the desired metal nitride.

A preferred method of producing a flux of neutral metal atoms is by the described practice of conventional magnetron sputtering. However, other cathodic or non-cathodic processes such as electron beam evaporation may be used to produce a flux of metal atoms for metal nitride synthesis in the inductively-coupled plasma.

This method is useful for applying transition metal nitride coatings on virtually any substrate or workpiece that is stable in the plasma environment. The workpiece may be, for example, metallic, ceramic or a synthetic resin. The process is particularly useful for coating workpieces that may be sensitive to temperatures higher than 175°C or so because the synthesis can be carried out at much lower temperatures as has been demonstrated. The experiments described above were conducted on flat pieces, but the plasma readily envelops three-dimensional workpieces and parts of virtually any shape can be coated. One attractive use in the automotive field is in the coatings of hardened steel parts such as gears, bearings or the like. Transmission gears, such as carburized and case hardened steel gears or hardenable alloy steel gears (e.g., SAE-4620H or SAE-8620H alloys), are examples of parts to be coated at temperatures of 175°C, or even 100°C or below, to avoid loss of hardness during the coating process.

It is recognized that capacitively coupled plasmas (CCP) have been used in sputter coating operations and the like. However, the use of CCPs is not considered suitable for the practice of this invention because the plasma density of CCP is not as high as that of ICP and does not enable the formation of dense, crystalline coatings of transition metal nitrides at low temperatures as described herein.

While this invention has been described in terms of some specific embodiments, it will be appreciated that other forms can readily be adapted by one skilled in the art. Accordingly, the scope of this invention is to be considered limited only by the following claims.

## Claims

1. A method of forming a transition metal nitride coating on a workpiece surface at a temperature of about 175°C or lower, said method comprising the following steps carried out in a subatmospheric pressure medium initially consisting essentially of an inert gas and nitrogen,

   producing a flow of atoms of said transition metal to a cooled, negatively biased (35) workpiece (34),
   forming through inductive coupling (30) a radio frequency electrical current-induced plasma (44) comprising positively charged inert gas and nitrogen ions at said workpiece surface, and
   controlling the flow of said metal atoms, the negative bias of said substrate and the power of the radio frequency current to produce a ratio of positive inert gas and nitrogen ions to metal atoms to form said metal nitride coating at a said temperature.

2. A method of forming a transition metal nitride coating on a workpiece surface at a temperature of about 175°C or lower, said method comprising the following steps carried out in a subatmospheric pressure medium initially consisting essentially of an inert gas and nitrogen,

sputtering atoms of said transition metal from a direct current powered, cathodic magnetron target to a cooled, negatively-biased workpiece substrate,
forming through inductive coupling a radio frequency electrical current-induced plasma comprising positively charged inert gas and nitrogen ions at said substrate surface, and
controlling the power of said cathodic target, the negative bias of said substrate and the power of the radio frequency current to produce a ratio of positive inert gas and nitrogen ions to metal atoms to form said metal nitride coating at a said temperature.

3. A method as recited in claim 1 or 2 in which said transition metal is an element selected from the group consisting of chromium, hafnium, niobium, tantalum, titanium, tungsten and zirconium

4. A method as recited in any of claims 1-3 in which said substrate is a steel and said substrate is maintained at a temperature below 175°C during the formation of said nitride coating.

5. A method of forming a titanium nitride coating on a steel substrate surface at a temperature of about 175°C or lower, said method comprising the following steps carried out in a subatmospheric pressure medium initially consisting essentially of argon and nitrogen,

sputtering titanium atoms from a direct current powered, cathodic magnetron target to a cooled, negatively-biased workpiece substrate,
forming through inductive coupling a radio frequency electrical current-induced plasma comprising positively charged inert gas and nitrogen ions at said substrate surface, and
controlling the power of said cathodic target, the negative bias of said substrate and the power of the radio frequency current to produce a ratio of positive inert gas and nitrogen ions to sputtered titanium atoms to form said titanium nitride coating at a said temperature.

6. A method as recited in claim 5 in which said substrate is maintained at a bias of -10V to -100V, said titanium sputtering target is maintained at -300V to -600V and said plasma is formed by two planar, helical induction coils carrying said radio frequency electrical current at a total power level such that the ratio of positive inert gas and nitrogen ions to sputtered atoms ranges from 10 to 60.

7. A method as recited in claim 1 or 2 in which a transition metal nitride coating is formed to a thickness in the range of about one-half micrometer to about five micrometers.

8. A method as recited in claim 5 or 6 in which said titanium nitride coating is formed to a thickness in the range of about one-half micrometer to about five micrometers.

9. A method as recited in any of claims 1-8 in which the ratio of the ion flux density to metal atom flux density is maintained in the range of 10 to 60.

10. A substrate having a transition metal nitride coating formed by a method recited in any of claims 1 through 9.

11. A steel substrate having a transition metal nitride coating formed by a method recited in any of claims 1 through 9.

12. A carburized and case-hardened steel substrate having a transition metal nitride coating formed by a method recited in any of claims 1 through 9.

FIG. 1

FIG. 2 A

FIG. 2B

FIG. 3

FIG. 4

FIG. 5

FIG. 6

FIG. 7

FIG. 8

BIAS 20V ICP 1100W  TiN 11271
BIAS 20V ICP 900W   TiN 11131
BIAS 20V ICP 600W   TiN 11122
BIAS 20V ICP   0W   TiN 11121

FIG. 9

FIG. 10